(19) Europäisches Patentamt / European Patent Office / Office européen des brevets

(11) **EP 2 476 511 B1**

(12) **EUROPÄISCHE PATENTSCHRIFT**

(45) Veröffentlichungstag und Bekanntmachung des Hinweises auf die Patenterteilung:
**27.03.2013 Patentblatt 2013/13**

(51) Int Cl.:
***B23Q 17/09*** *(2006.01)*

(21) Anmeldenummer: **11150997.2**

(22) Anmeldetag: **14.01.2011**

(54) **Vorrichtung und Verfahren zum Überwachen einer Werkzeugmaschine**

Device and method for monitoring a machine tool

Dispositif et procédé destinés à la surveillance d'une machine-outil

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**18.07.2012 Patentblatt 2012/29**

(73) Patentinhaber: **ARTIS GmbH**
**29646 Bispingen-Behringen (DE)**

(72) Erfinder:
• **Lange, Dirk**
**21335, Lüneburg (DE)**
• **Redecker, Volker**
**29646, Bispingen (DE)**
• **Messing, Heribert Josef**
**48624, Schöppingen (DE)**

(74) Vertreter: **Wegner, Hans**
**Bardehle Pagenberg Partnerschaft**
**Patentanwälte, Rechtsanwälte**
**Prinzregentenplatz 7**
**81675 München (DE)**

(56) Entgegenhaltungen:
**EP-A1- 2 165 803    WO-A1-2006/128892**
**US-A- 4 786 220**

**Beschreibung**

## 1. Technisches Gebiet

Die vorliegende Erfindung betrifft eine Vorrichtung und ein Verfahren zum Überwachen einer Werkzeugmaschine.

## 2. Der Stand der Technik

Heutzutage werden hohe Anforderungen an die Wirtschaftlichkeit und Produktivität von Fertigungsanlagen gestellt. Auf der anderen Seite bestehen aber auch hohe Ansprüche an die Qualität der gefertigten Werkstücke. Diese gegenläufigen Zielsetzungen lassen sich zumeist nur durch einen hohen Automatisierungsgrad erreichen. Dabei erfordert ein weitgehend automatischer Betrieb einer Werkzeugmaschine das Ausnutzen der Daten verschiedener Sensorsysteme, um die Maschine wirksam regeln und damit kontrollieren zu können.

Der Zustand des Werkzeugs, das zur Bearbeitung eines Werkstücks eingesetzt wird, hat einen wesentlichen Einfluss auf die Qualität des zu fertigenden Werkstücks. Wird in automatisierten Fertigungseinrichtungen ein fehlendes oder gebrochenes Werkzeug nicht oder nicht rechtzeitig erkannt, kann dies zu hohen Ausschussraten führen. Im schlimmsten Fall werden fehlerbehaftete Werkstücke oder Bauteile in ein Endprodukt eingebaut, was hohe Schäden auf der Kundenseite zur Folge haben kann.

Die angesprochene Problematik gilt in gleichem Maße, wenn nicht korrekte Werkstücke nicht oder nicht rechtzeitig erkannt werden und somit durch die Fertigungslinie bearbeitet werden. Diese müssen am Ende der Bearbeitung verworfen werden oder werden fälschlicherweise in einem Endprodukt verbaut. Es ist daher sehr wichtig, solche Fehlerquellen rechtzeitig zu erkennen und zu beseitigen.

Derzeit gibt es bereits eine Anzahl von Systemen und Vorrichtungen zur Werkzeugüberwachung. Zum einen basieren diese Systeme auf der direkten oder indirekten Messung der bei der Zerspanung umgesetzten Leistung. Ein Beispiel der direkten Leistungsmessung ist in der Patentschrift DD 247 402 A1 beschrieben.

Die WO 2006/128892 A1 offenbart ein Verfahren und eine Vorrichtung zur Brucherkennung von Werkzeugen, die Werkstücke mit guter elektrischer Leitfähigkeit wie Metalle spanabhebend bearbeiten. Dabei sieht das Verfahren vor, dass mindestens eine von dem Kontaktzustand abhängige und erfassbare elektrische Messgröße wie der elektrische Widerstand, die elektrische Leitfähigkeit, die elektrische Induktivität, die elektrische Kapazität oder die elektrische Impedanz zu Beginn, während und zum Ende eines Bearbeitungszyklus bzw. Bearbeitungsabschnitts gemessen wird und dass die Signalverläufe mit festlegbaren Schwellenwerten verglichen werden.

Die EP 2 165 803 A1 offenbart ein System zum Überwachen und zum Kontrollieren des Werkzeugs und des Kopfes einer Werkzeugmaschine, wobei ein elektrischer Schaltkreis zwischen dem Werkzeug und dem Kopf der Werkzeugmaschine einen Abschnitt mit einem Material umfasst, das unter normalen Umständen kein elektrischer Leiter ist. Ein Signalgenerator erzeugt ein Signal im Frequenzbereich von 1 MHz bis 60 MHz dessen Spannungsvariation von der Impedanz des Schaltkreises beeinflusst wird.

Das US Patent US 3 786 220 offenbart ein Verfahren durch welches der Abnutzungsgrad und sinnvolle Lebensdauerbegrenzungen eines Bohrers, eines Fräsers oder anderer Arten von spanabhebenden Werkzeugen detektiert werden können. Das Verfahren basiert auf einem Kurzschlussstrom, einer offenen Klemmenspannung und/oder elektrischer Energie, die während der Metallentfernung unter Verwendung eines isolierten rotierenden Messers, das mit einem nicht rotierenden Leiter und einem isolierten oder nicht isolierten Werkstück in elektrischem Kontakt steht, mit einem externen Schaltkreis erzeugt wird, der das Werkzeug und das Werkstück mittels eines Messgeräts verbindet.

Zur indirekten Messung des Drehmoments zur Werkzeugüberwachung können beispielsweise Piezooxide auf dem Werkzeug angebracht werden, wie dies beispielsweise in der Offenlegungsschrift DE 29 06 892 ausgeführt ist. Die Patentschrift DE 10 2006 834 und die Offenlegungsschrift DE 10 2004 051 145 A1 der Anmelderin beschreiben wie Signale, die von verschiedenen auf der Spindel der Werkzeugmaschine angeordneten Sensoren aufgenommen werden, drahtlos an eine ortfeste Empfangseinheit übertragen werden können.

Der Ansatz über die direkte Messung ist in der Praxis bereits vielfach erprobt; er setzt jedoch eine Mindestzerspanleistung voraus, die über der Rauschgrenze des jeweiligen Messsignals (z.B. der Wirkleistung) liegt. Bei kleinen Werkzeugdurchmessern (z.B. < 1 mm Durchmesser), die besonders anfällig für Brüche sind, ist diese Vorraussetzung jedoch oftmals nicht gegeben. Die indirekten Messverfahren sind aufwändig und häufig schwierig nachträglich in bereits bestehende Systeme zu integrieren, was ihrem Einsatz unter Fertigungsbedingungen ganz wesentlich behindert.

Darüber hinaus gibt es eine Vielzahl weiterer Verfahren, um das Werkzeug vor bzw. nach dessen Einsatz zu vermessen. Die Auslegeschrift DE 1 033 991 offenbart beispielsweise ein induktives Verfahren zur Bestimmung der Länge eines Bohrers nach dessen Einsatz. Dieses Verfahren bestimmt zwar, ob die Länge des Bohrers vor und nach der Bearbeitung im Wesentlichen übereinstimmt. Dieses Verfahren kann jedoch nicht eingesetzt werden, um festzustellen, ob der richtige Bohrer verwendet wird oder ob überhaupt ein Werkstück vorhanden ist.

Optische Verfahren zum Bestimmen der Werkzeuggeometrie sind in der Umgebung von Werkzeugmaschinen aufgrund des hohen Verschmutzungsgrads oftmals nur begrenzt einsetzbar. Beim Einsatz von takilen Verfahren kann es zu Messunsicherheiten kommen, die durch Kühlmittel und/oder Späne hervorgerufen werden. Bei sehr kleinen Werkzeugen kann zudem das An- oder Abtasten des Werkzeugs selbst zu dessen Zerstörung führen. Außerdem erfordert der Einbau derartiger Überwachungssysteme in bereits bestehende Anlagen einen erheblichen Integrationsaufwand.

Ein generelles Handicap aller Pre- und/oder Postprozessvermessungen liegt darin, dass sie Messzeiten benötigen, in denen die Maschine nicht für die Bearbeitung von Werkstücken zur Verfügung steht. Dieser Nachteil lässt oftmals einen wirtschaftlichen Einsatz dieser Verfahren nicht zu.

Der vorliegenden Erfindung liegt daher das Problem zugrunde, eine einfache, robuste und kostengünstig einsetzbare Vorrichtung sowie ein entsprechendes Verfahren bereitzustellen, mit denen das Werkzeug einer Werkzeugmaschine und das entsprechende Werkstück einfach und zuverlässig überwacht werden können.

### 3. Zusammenfassung der Erfindung

Dieses Problem wird gemäß einem ersten Aspekt der Erfindung durch eine Vorrichtung nach Anspruch 1 gelöst. In einer Ausführungsform umfasst eine Vorrichtung zum Überwachen des Betriebs eines elektrisch leitfähigen Werkzeugs einer Werkzeugmaschine zumindest eine elektrisch leitfähige Spindel zur Aufnahme des Werkzeugs, einen Detektor, der einen elektrischen Widerstand zwischen der Spindel und einem zu bearbeitenden, elektrisch leitfähigen Werkstück bestimmt, und wobei die Spindel von der Werkzeugmaschine elektrisch isoliert ist und/oder die Vorrichtung ausgebildet ist, um das zu bearbeitende Werkstück elektrisch von der Werkzeugmaschine zu isolieren.

Anders als mit den oben erläuterten Systemen aus dem Stand der Technik ermöglicht eine erfindungsgemäße Vorrichtung die Überwachung des Werkzeugs allein durch das Messen des elektrischen Widerstands zwischen der Spindel und dem Werkstück. Ferner erlaubt eine erfindungsgemäße Vorrichtung während des Bearbeitungsprozesses vorzugsweise in Echtzeit den Bruch des Werkzeugs zu detektieren. Damit können sofort geeignete Gegenmaßnahmen eingeleitet werden, wie etwa das Abschalten des Vorschubs und/oder der Rotation des Werkzeugs, wodurch die Folgeschäden des Werkzeugbruchs sowohl für das Werkstück, aber insbesondere für die Werkzeugmaschine minimiert werden können.

Die einzige Vorraussetzung für den Einbau einer erfindungsgemäßen Vorrichtung ist das Auftrennen der elektrischen Masse der Werkzeugmaschine an einem der beiden Messpunkte der elektrischen Widerstandsmessung. Dadurch dass ein Messpunkt von der Masse der Werkzeugmaschine isoliert wird, wird es möglich eine definierte Spannung zwischen Spindel und Werkstück anzulegen mit deren Hilfe der ohmsche Widerstand zwischen Spindel und Werkstück gemessen werden kann. Der Einbau der definierten Vorrichtung in eine Maschine ist sehr einfach. Die Vorrichtung selber kann mit konventionellen Standardkomponenten ausgeführt werden. Ferner ist der Betrieb einer erfindungsgemäßen Vorrichtung ebenfalls äußerst simpel und dadurch sehr robust.

Insbesondere beeinträchtigt eine erfindungsgemäße Vorrichtung den Bearbeitungsprozess der Werkzeugmaschine nicht. Es werden keine Messzeiten benötigt, in denen die Maschine nicht für Bearbeitungsprozesse zur Verfügung steht und die den Durchsatz der Maschine nachteilig beeinflussen. Somit kann mit einer erfindungsgemäßen Vorrichtung eine wirtschaftliche Überwachung des Betriebs eines elektrisch leitfähigen Werkzeugs einer Werkzeugmaschine und eines zu bearbeitenden, elektrisch leitfähigen Werkstücks ausgeführt werden.

Durch das Auftrennen der elektrischen Masse der Werkzeugmaschine an einer Stelle und das Anlegen einer elektrischen Spannungen an die Spindel und/oder das Werkstück bzw. den Werktisch der Werkzeugmaschine liegen verschiedene Teile der Maschine auf verschiedenen elektrischen Potentialen. Die Spannungen und Ströme, die für eine zuverlässige Messung des elektrischen Widerstands zwischen Spindel und Werkzeug benötigt werden sind so gering, dass sie den Betrieb der Werkzeugmaschine nicht beeinträchtigen können. Noch viel wichtiger ist jedoch ist, dass die unterschiedlichen Potentiale der Maschine für das Bedienpersonal ohne Gefährdung sind und dieses nicht schädigen können.

Die Spannungen mit der eine erfindungsgemäße Vorrichtung arbeitet liegen im Niederspannungsbereich, vorzugsweise unter 30 V. Durch den Einbau eines geeigneten Strombegrenzers beispielsweise in Form eines Widerstands kann die Stromhöhe auch im Falle eines unbeabsichtigten Kurzschlusses auf ein Niveau begrenzt werden, das weder die Maschine noch das Bedienpersonal schädigen können.

Die Vorrichtung weist ferner einen Spannungsteiler auf, der zumindest zwei Widerstände umfasst, wobei ein Mittenabgriff des Spannungsteilers elektrisch leitfähig mit der Spindel und dem Detektor verbunden ist und wobei ein Ende des Spannungsteilers elektrisch leitfähig mit dem Werkstück verbunden ist.

Durch eine geeignete Wahl der Widerstände des Spannungsteilers kann die Größe des Messsignals an die Größe des zu messenden Widerstands angepasst werden. Durch den Einsatz eines Spannungsteilers wird automatisch ein Strombegrenzer in eine erfindungsgemäße Vorrichtung eingebaut. Darüber hinaus kann in einer Ausführungsform der Vorrichtung, die einen Spannungsteiler umfasst, anstelle einer Spannungsquelle auch eine Stromquelle in dem Detektor eingesetzt werden.

Gemäß einem weiteren Aspekt umfasst die Spindel ein Spindelgehäuse und eine Spindelwerkzeugaufnahme, wobei das Spindelgehäuse gegenüber der Werkzeugmaschine elektrisch isoliert ist, und an den Detektor oder den Mittenabgriff des Spannungsteilers angeschlossen ist.

In einem anderen Aspekt ist der Detektor ausgestaltet, einen Alarm zu erzeugen. In sehr einfachen Ausführungen einer erfindungsgemäßen Vorrichtung gibt der Detektor nach dem Feststellen einer Störung des Betriebs der Werkzeugmaschine ein akustisches und/oder ein optisches Alarmsignal ab. Dieses Signal ermöglicht es dem Bedienpersonal, den Betriebszustand der Maschine zu kontrollieren und die entsprechenden Gegenmaßnahmen einzuleiten. In Maschinen, die für einen automatisierten oder weitgehend automatisierten Betrieb ausgelegt sind, liefert der Detektor die festgestellte Störung an das Überwachungssystem der Maschine und das Überwachungssystem leitet automatisch die geeigneten Maßnamen ein.

Gemäß einem weiteren Aspekt umfasst die Werkzeugmaschine mehrere elektrisch von der Werkzeugmaschine isolierte Spindeln.

Moderne Werkzeugmaschinen umfassen vielfach mehrere Spindeln. Für jede Spindel kann eine eigene Überwachungsvorrichtung eingesetzt werden. Die Auslegung der Vorrichtung kann zudem an die Ausführung der jeweiligen Spindel angepasst werden. In einer alternativen Ausführungsform können mehrere elektrisch isolierte Spindeln an eine einzige Vorrichtung zur Widerstandsmessung angeschlossen werden. Um eine sichere Überwachung des gleichzeitigen Betriebs mehrerer Spindeln zu gewährleisten, wird der Detektor der Vorrichtung entsprechend angepasst.

In einem anderen Aspekt ist das Werkstück auf einem elektrisch leitfähigen Werktisch der Werkzeugmaschine angeordnet und der Detektor ist elektrisch leitend mit dem Werktisch verbunden.

Ein Vorteil dieser Ausführungsform ist, dass der elektrische Kontakt zum Detektor nicht für von jedem fertig bearbeitenden Werkstück abgezogen werden muss und das neu zu bearbeitende Werkstück muss nicht kontaktiert werden. Damit kann bei manueller Bedienung einer erfindungsgemäßen Vorrichtung die elektrische Kontaktierung des Werkstücks nicht vergessen werden.

In einem bevorzugten Aspekt ist das Werkstück auf einem elektrisch isolierenden Werktisch der Werkzeugmaschine angeordnet oder der elektrisch leitfähige Werktisch ist elektrisch von der Werkzeugmaschine isoliert und der Detektor ist elektrisch leitend mit dem Werkstück oder mit dem elektrisch von der Werkzeugmaschine isolierten, elektrisch leitfähigen Werktisch verbunden.

In dieser Ausführung einer erfindungsgemäßen Vorrichtung muss die Spindel bzw. das Spindelgehäuse nicht von der elektrischen Masse der Werkzeugmaschine getrennt werden. Vielmehr genügt es in einer sehr einfachen Ausführungsform durch eine elektrisch nicht leitende oder isolierende Unterlage zwischen Werktisch und Werkstück letzteres elektrisch von der elektrischen Masse der Werkzeugmaschine zu trennen. Dadurch wird der Integrationsaufwand einer erfindungsgemäßen Vorrichtung in bereits bestehende Anlagen auf ein Minimum reduziert.

Nach einem weiteren bevorzugten Aspekt ist eine Werkstückspannvorrichtung ausgebildet, das Werkstück elektrisch isoliert von der Werkzeugmaschine zu spannen.

Eine Werkstückspannvorrichtung, die das Werkstück auf dem Werkstisch elektrisch isoliert von der Maschinenmasse fixiert, hat den Vorteil, dass die elektrische Masse der Werkzeugmaschine nicht verändert werden muss. Die Umbaumaßnahmen der Maschine beschränken sich auf den Austausch der Spannvorrichtung für das Werkstück. Zudem stellt eine professionelle elektrisch isolierende Spannvorrichtung sicher, dass das Werkstück einerseits sicher fixiert werden kann und andererseits das Potential des Werkstücks zuverlässig von der elektrischen Masse der Werkzeugmaschine getrennt ist.

Gemäß einem anderen Aspekt umfasst der Detektor einen Stromdetektor und eine Spannungsquelle oder der Detektor umfasst ein Spannungsquelle oder eine Stromquelle und einen Spannungsdetektor.

Eine Vorrichtung zur Messung des Widerstands zwischen Spindel und Werkstück kann aus herkömmlichen Standardkomponenten aufgebaut werden. Diese sind über den benötigten Wertebereich hinweg im Markt vorhanden. Damit kann eine Vorrichtung für eine vorgegebene Maschine optimal ausgelegt werden. Die benötigten Standardkomponenten sind vielfach erprobt, zuverlässig und kostengünstig verfügbar.

In einem weiteren bevorzugten Aspekt ist der Detektor ausgebildet, um festzustellen, dass die Spindel, das Werkzeug und das Werkstück (a) einen ersten elektrischen Widerstand bilden, wenn das Werkzeug nicht mit dem Werkstück in Kontakt ist oder kein Werkzeug oder Werkstück vorhanden ist, (b) einen zweiten elektrischen Widerstand bilden, wenn das Werkzeug mit dem Werkstück in Kontakt ist, oder (c) einen dritten elektrischen Widerstand bilden, wenn das Werkzeug mit dem Werkstück in Kontakt ist und das Werkzeug und/oder das Werkstück defekt sind.

Die Messung des elektrischen Widerstands zwischen dem Spindelgehäuse und dem Werkstück liefert Zahlenwerte in drei verschiedenen Bereichen. Der erste Widerstand $R_1$ ist im Wesentlichen unendlich groß, da der Kontaktwiderstand zwischen dem Werkzeug und dem Werkstück, die nicht miteinander in Kontakt stehen, d.h. durch einen Luftspalt von einander getrennt sind, diesen Zahlenwert bewirkt. In diesem Zusammenhang wie auch in den weiteren Ausführungen dieser Beschreibung bedeutet ein unendlicher Widerstand einen Zahlenwert des ohmschen Widerstands der oberhalb der Messgrenze des eingesetzten Detektors liegt.

Der zweite elektrische oder ohmsche Widerstand $R_2$ liegt in dem Bereich von einigen $\Omega$ bis einigen k$\Omega$ und

wird zum überwiegenden Teil durch die Kontaktwiderstände zwischen der Spindelwerkzeugaufnahme und dem Werkzeug und zwischen dem Werkzeug und dem Werktisch bestimmt. Der dritte Widerstand $R_3$ weist Zahlenwerte in einem Intervall auf, das von dem k$\Omega$-Bereich bis in den G$\Omega$-Bereich reicht. Allgemein gilt für den Zusammenhang der Zahlenwerte des ohmschen Widerstands: $R_1 \geq R_3 > R_2$.

In noch einem anderen bevorzugten Aspekt ist der Detektor ferner ausgebildet, um festzustellen, dass ein nicht korrektes Werkzeug oder ein nicht korrektes Werkstück vorliegt, wenn ein Übergang von dem ersten elektrischen Widerstand zu dem zweiten elektrischen Widerstand bei einem Abstand zwischen Spindel und Werkstück auftritt, der größer als ein vorgegebener Abstand ist. Gemäß einem weiteren Aspekt ist der Detektor ferner ausgebildet, um festzustellen, dass ein korrekter Betrieb der Werkzeugmaschine vorliegt, wenn der Übergang von dem ersten elektrischen Widerstand zu dem zweiten elektrischen Widerstand innerhalb eines vorgegebenen Abstandsintervalls zwischen Spindel und Werkstück auftritt. In noch einem anderen Aspekt ist der Detektor ferner ausgebildet, um festzustellen, dass das Werkzeug fehlt, wenn kein Übergang von dem ersten zu dem zweiten elektrischen Widerstand innerhalb eines vorgegebenen Abstandsintervalls zwischen Spindel und Werkstück auftritt. Nach einem weiteren günstigen Aspekt ist der Detektor ferner ausgebildet, um festzustellen, dass ein nicht korrektes Werkzeug oder ein nicht korrektes Werkstück vorliegt, wenn ein Übergang von dem ersten elektrischen Widerstand zu dem zweiten elektrischen Widerstand bei einem Abstand zwischen Spindel und Werkstück auftritt, der kleiner als ein vorgegebener Abstand ist. In noch einem anderen Aspekt ist der Detektor ferner ausgebildet, um festzustellen, dass ein defektes Werkzeug oder ein defektes Werkstück vorliegt, wenn ein Übergang von dem zweiten elektrischen Widerstand zu dem dritten elektrischen Widerstand auftritt.

Eine erfindungsgemäße Vorrichtung kann somit nicht nur dazu eingesetzt werden, das Fehlen oder einen Bruch des Werkzeugs der Werkzeugmaschine zu bestimmen. Vielmehr kann eine oben definierte Vorrichtung auch dazu benutzt werden zu detektieren, ob das eingesetzte Werkstück richtig positioniert ist oder ob überhaupt das richtige Werkstück in der Maschine vorhanden ist.

In noch einem weiteren Aspekt ist der Detektor ausgebildet, um zu überwachen, dass der Verlauf des elektrischen Widerstands beim Bearbeiten des Werkstücks im Wesentlichen einem vorgegebenen Verlauf folgt. Gemäß einem anderen bevorzugten Aspekt liegt der Verlauf des elektrischen Widerstands beim Bearbeiten des Werkstücks unterhalb einer ersten vorgegebenen Hüllkurve und oberhalb einer zweiten vorgegebenen Hüllkurve. In einem anderen günstigen Aspekt liegt der Verlauf des elektrischen Widerstands beim Bearbeiten des Werkstücks innerhalb vorgegebener Flächenwerte.

Anders als in der oben erläuterten, einfachen Ausführung, in der der Detektor einen Alarm signalisiert, kann der Detektor die Funktion umfassen, seine Widerstandsmesswerte nach einer entsprechenden Aufbereitung an das Überwachungssystem der Werkzeugmaschine weiterzuleiten. Das Überwachungssystem der Maschine bzw. dessen Bildschirm oder Monitor visualisiert den Verlauf der Widerstandsmessung in der Art mit der auch die weiteren Betriebskenngrößen der Maschine auf dem Bildschirm dargestellt werden. Damit können die Messdaten einer Vorrichtung zur Widerstandsmessung zwischen Spindel und Werkstück in einer für das Bedienpersonal vertrauten Form veranschaulicht werden.

Gemäß einem weiteren Aspekt ist der Detektor mit einem Überwachungssystem der Werkzeugmaschine verbunden, und das Überwachungssystem ist ausgestaltet, den Betrieb der Werkzeugmaschine zu unterbrechen.

Durch die Rückkopplung einer erfindungsgemäßen Vorrichtung mit dem Überwachungssystem der Werkzeugmaschine kann dieses praktisch in Echtzeit auf die Messwerte der Widerstandsmessung des Detektors reagieren. Das Überwachungssystem schaltet bei Bedarf den Vorschub und/oder die Rotation des Werkzeugs mit minimaler Zeitverzögerung ab. Die Folgeschäden, die an dem Werkstück und/oder der Maschine beim Feststellen eines Werkzeugbruchs entstehen, können dadurch auf ein Minimum reduziert werden.

Die Datenübertragung zwischen Detektor und Überwachungssystem muss nicht auf eine Richtung beschränkt sein. Vielmehr kann der Detektor ausgelegt sein, um von dem Überwachungssystem der Maschine kontrolliert zu werden.

Schließlich weist in einem besonders bevorzugten Aspekt ein Verfahren gemäß Anspruch 13 zum Überwachen einer Werkzeugmaschine mit einer elektrisch leitfähigen Spindel beim Bearbeiten eines elektrisch leitfähigen Werkstücks, den Schritt des Bestimmens einer Änderung des elektrischen Widerstands zwischen der Spindel und dem Werkstück auf. Dabei nimmt die Spindel ein elektrisch leitfähiges Werkzeug auf und die Spindel und/oder das Werkstück ist elektrisch von der Werkzeugmaschine isoliert.

Weitere Fortentwicklungen der Erfindung finden sich in weiteren abhängigen Ansprüchen.

## 4. Kurze Beschreibung der Zeichnungen

In der nachfolgenden detaillierten Beschreibung werden derzeit bevorzugte Ausführungsbeispiele der vorliegenden Erfindung unter Bezugnahme auf die begleitenden Figuren erläutert, wobei

Fig. 1    eine schematische Darstellung einiger Komponenten einer Werkzeugmaschine, des Werkstücks und eine eingebaute erfindungsgemäße Vorrichtung zeigt (linkes oberes Teilbild), deren elektrisches Ersatzbild darstellt (rechtes oberes Teilbild) sowie ein einfaches Ausführungsbeispiel einer Vorrichtung zur Widerstandsmessung veranschaulicht (unteres Teilbild);

Fig. 2 die Fig. 1 veranschaulicht bei der das Werkzeug der Werkzeugmaschine mit dem Werkstück in Kontakt ist;

Fig. 3 die Fig. 1 darstellt nachdem das Werkzeug während eines Bohrprozesses gebrochen ist;

Fig. 4 die Fig. 1 wiedergibt, bei der die elektrische Masse nicht an der Spindel der Werkzeugmaschine aufgetrennt ist, sondern an dem Werktisch der Werkzeugmaschine;

Fig. 5 die Fig. 1 wiedergibt, bei der der Detektor zum Widerstandsmessen zusätzlich einen Spannungsteiler umfasst, der zwischen den Messpunkten an der Werkzeugmaschine und dem Messdetektor eingebaut ist;

Fig. 6 die Fig. 5 darstellt bei der der Detektor an das Überwachungssystem der Werkzeugmaschine angeschlossen ist;

Fig. 7 schematisch ein Ablaufdiagramm des Verfahrens in einem Ausführungsbeispiel veranschaulicht;

Fig. 8 den Verlauf einer Darstellung des Widerstandsmesssignals veranschaulicht, wenn das Werkstück an der zu bearbeitenden Stelle zu hoch ist und/oder die Spindel ein falsches Werkzeug trägt (Prozess nicht in Ordnung);

Fig. 9 einen beispielhaften Verlauf einer Darstellung des Widerstandsmesssignals für einen normalen Verlauf des Bearbeitungsprozess zeigt (Prozess in Ordnung); und

Fig. 10 den Verlauf einer Darstellung des Widerstandsmesssignal wiedergibt, wenn kein Werkzeug in die Werkzeugaufnahme der Spindel eingebaut ist (Prozess nicht in Ordnung).

## 5. Detaillierte Beschreibung bevorzugter Ausführungsbeispiele

Im Folgenden werden gegenwärtig bevorzugte Ausführungsbeispiele der erfindungsgemäßen Vorrichtung und des erfindungsgemäßen Verfahrens zum Überwachen einer Werkzeugmaschine genauer erläutert. Diese werden dabei im Zusammenhang mit einer Werkzeugmaschine mit einer Spindel und einem Werkzeug beschrieben.

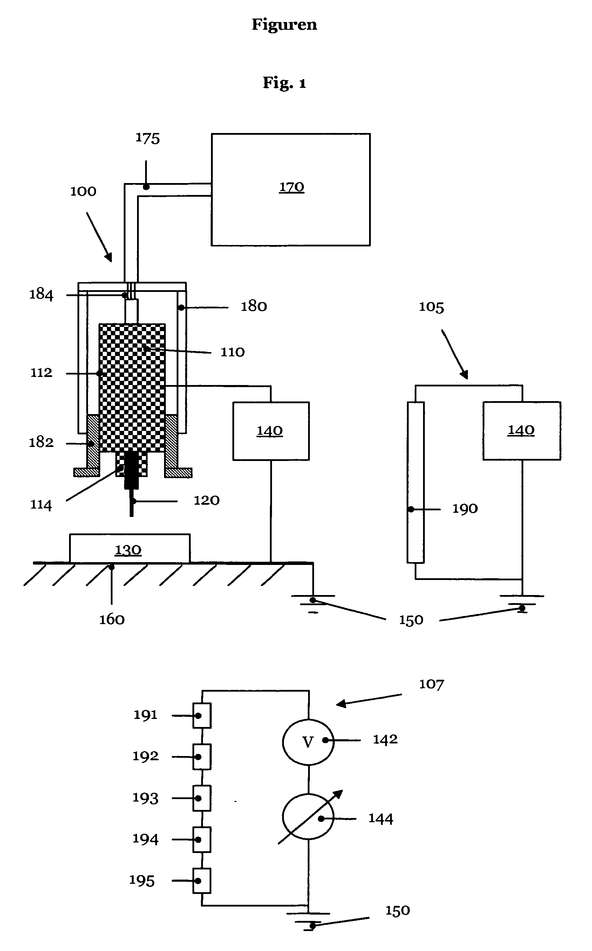

Die Fig. 1 zeigt im linken oberen Teilbild eine schematische Darstellung einiger wichtiger Komponenten einer Werkzeugmaschine 100. Diese weist eine Spindel 110 mit einem Spindelgehäuse 112 und einer Werkzeugaufnahme 114 auf. Das Spindelgehäuse 112 und die Aufnahme für das Werkzeug 114 sind elektrisch leitend miteinander verbunden. Eine Isolierhülse 182, die zumindest auf den Außenseiten elektrisch isolierendes Material aufweist, trennt das Schutzgehäuse 180 von dem Gehäuse 112 der Spindel 110.

Der Umrichter 170 versorgt die Spindel 110 mit elektrischer Energie. Die elektrische Masse der Zuleitung 175 ist mit dem Schutzgehäuse 180 der Spindel 110 verbunden und die Phasen 184 der elektrischen Zuleitung 175 werden der Spindel 110 zugeführt. Damit ist das Spindelgehäuse 112 elektrisch von der elektrischen Masse der Werkzeugmaschine 100 entkoppelt. Das Schutzgehäuse 180 der Spindel 110 ist jedoch an die elektrische Masse 150 der Werkzeugmaschine 100 (Maschinenmasse 150) angeschlossen.

In die Werkzeugaufnahme 114 ist ein elektrisch leitfähiges Werkzeug 120 eingesetzt. In dem in der Fig. 1 dargestellten Beispiel trägt die Werkzeugaufnahme 114 einen Bohrer. Die Werkzeugaufnahme 114 der Spindel 110 ist jedoch nicht auf den Einsatz eines Bohrers beschränkt. Vielmehr kann die Spindel 110 alle Arten rotierender Werkzeuge 120 aufnehmen, wie beispielsweise Fräser, Räumwerkzeuge oder Gewindeschneider.

Das Werkzeug 120 ist auf das zu bearbeitende Werkstück 130 gerichtet, das auf dem Werktisch 130 der Werkzeugmaschine 100 angeordnet ist. Das Werkstück 130 muss elektrisch leitfähig sein. Damit lassen insbesondere alle Arten metallischer Werkstücke, Legierungen oder Gussteile den Einsatz einer Ausführungsform der Vorrichtung zum Messen des Widerstands zwischen Spindel und Werkstück zu. Ansonsten werden keine Anforderungen an das zu bearbeitende Werkstück 130 gestellt. In dem Beispiel der Fig. 1 ist die elektrische Masse 150 der Werkzeugmaschine 100 (Maschinenmasse 150) an dem Werktisch 160 zusammengeführt.

Zwischen das elektrisch isolierte Spindelgehäuse 112 der Spindel 110 und den Werktisch 160 der Werkzeugmaschine 100 wird der Detektor 140 eingebaut bzw. angeschlossen. Das elektrische Ersatzschaltbild 105 des für die Widerstandsmessung relevanten Teils der Werkzeugmaschine 100 und des Detektors 140 ist in dem rechten oberen Teilbild der Fig. 1 dargestellt. Ein elektrischer Widerstand 190 wird von dem Detektor 140 gemessen.

Das im unteren Teilbild der Fig. 1 veranschaulichte Ausführungsbeispiel 107 zeigt eine sehr einfache Ausführungsform des Detektors 140 und schematisch die wesentlichen Komponenten des Widerstands 190 der Ersatzschaltung 105. In dem einfachen in der Fig. 1 dargestellten Ausführungsbeispiel 107 umfasst der Detektor 140 eine Spannungsquelle 142 mit einem in Reihe geschalteten Stromdetektor 144 in Form eines Amperemeters. Der Zahlenwert des Widerstands 190 wird gemäß dem Ohmschen Gesetz aus dem Quotienten aus der von der Spannungsquelle 142 erzeugten Potentialdifferenz und der von dem Amperemeter 144 gemessenen Stromstärke bestimmt.

In der gezeigten Ausführungsform ist die Spannungsquelle 142 einfach eine DC oder Gleichspannungsquelle, die eine feste oder einstellbare Spannung an ihren Ausgängen erzeugt. Die Größe der von der Spannungsquelle 142 erzeugten Potentialdifferenz hängt zum einen von der Größe des zu messenden Widerstands 190 ab und zum anderen von den Störungen, die die Werkzeugmaschine 100 oder deren Umgebung erzeugt. Der Zahlenwert, der an das Spindelgehäuse angelegten elektrischen Spannung, liegt für Spindeln mit Kugel- oder Rollenlagern im Bereich bis etwa 50 V. Vorzugsweise wird für diese Spindeln die Standard-Maschinenspannung von 24 V verwendet.

Um den Strom auch im Kurzschlussfall auf ein vorgegebenes Niveau zu begrenzen zu können, kann die Spannungsquelle 142 des Detektors 140 einen in Reihe geschalteten Widerstand enthalten (in der Fig. 1 nicht dargestellt). In anderen Ausführungsformen kann die Spannungsquelle 142 eine Wechselspannung einer geeigneten Frequenz generieren. Alternativ kann die Spannungsquelle 142 eine digitale Pulsfolge abgeben. Durch Verwenden einer geeigneten Trägerfrequenz und durch entsprechendes Anpassen des Strommessers 144 kann in einer durch HF Störungen verseuchten Umgebung die Empfindlichkeit der Strom- bzw. Spannungsmessung gesteigert werden.

In einer einfachen Ausführungsform umfasst der Detektor 140 neben einer Spannungsquelle 142 und einem Stromdetektor 144 zumindest noch ein Element, um ein Alarmsignal zu erzeugen (in der Fig. 1 nicht gezeigt). Das Element zum Generieren des Alarmsignals kann ein akustisches und/oder ein optisches Signal erzeugen.

Das Ausführungsbeispiel 107 gibt die wesentlichen Komponenten des Widerstands 190 der elektrischen Ersatzschaltung 105 an. Der Widerstand 191 repräsentiert den elektrischen Widerstand der Spindel 110, d.h. den ohmschen Widerstand von dem Spindelgehäuse 112 bis zu der Werkzeugaufnahme 114 der Spindel 110. Der Widerstand 191 umfasst neben dem Widerstand des Spindelgehäuses 112 und der Werkzeugaufnahme 114 auch den Widerstand des Lagers der Spindel und die Übergangswiderstände zwischen den einzelnen Komponenten der Spindel. Insbesondere der elektrische Widerstand innerhalb des Lagers, das rotierende Komponenten umfasst, ist sehr stark von dem individuellen Aufbau des Lagers und dessen Betriebszustand abhängig. Aus diesen Gründen schwankt der Widerstand 191 der Spindel deutlich. Der Widerstand 191 kann ferner einen temporären und/oder permanenten Parallelwiderstand beinhalten der durch Kühlmittel, Öl und/oder Schmutz auf der Spindel gebildet wird. Für kugel- oder rollengelagerte Spindeln 110 aus metallischen Bauteilen bleibt der Widerstand 191 jedoch immer im niederohmigen Bereich, d.h. < 1 kΩ. Für Spindeln 110 mit Magnetlagern oder Keramiklagern kann der Übergangswiderstand zwischen Spindelgehäuse 112 und Welle oder Werkzeugaufnahme 114 deutlich größer sein. Damit kann der elektrische Widerstand 191 für diese Spindeln 110 bis in den hochohmigen Bereich reichen.

Der Widerstand 193 berücksichtigt die ohmschen Verluste innerhalb des Werkzeugs 120. Da das Werkzeug 120 in der Regel aus hartem oder gehärteten Metall bzw. Metalllegierungen besteht, ist der Widerstand des Werkzeugs normalerweise klein; sein Zahlenwert hängt von dem Material sowie von der Geometrie des Werkzeugs 120 ab und liegt normalerweise im Bereich einiger mΩ bis einiger Ω. Dabei hat die Beschichtung des Werkzeugs 120 einen signifikanten Einfluss auf dessen ohmschen Widerstand 193.

Mit dem Widerstand 195 wird der elektrische Widerstand des Werkstücks 130 berücksichtigt. Der Widerstand 195 wird von dem Material des Werkstücks 130 sowie dessen Geometrie bestimmt. Für gebräuchliche Werkstücke 130, d.h. für Werkstücke die in großen Stückzahlen bearbeitet werden, liegt der Zahlenwert des Widerstands 195 unterhalb von 1 kΩ.

Der Widerstand 192 repräsentiert den Kontakt- oder Übergangswiderstand zwischen der Werkzeugaufnahme 114 der Spindel 110 und dem Schaft des Werkzeugs 120. Die numerische Größe des Widerstands 192 hängt von der Größe der Kontaktfläche zwischen der Werkzeugaufnahme 114 mit dem Schaft des Werkzeugs 120 ab. Des Weiteren hängt er wesentlich von der Oberflächenbeschaffenheit der beiden Komponenten 120 und 130 sowie von einer ggf. vorhandenen Beschichtung des Werkzeugs 120 ab. Darüber hinaus kann eine Verschmutzung der Aufnahme 114 und/oder des Werkzeugs 130 den Kontaktwiderstand 192 nachteilig beeinflussen. Der Zahlenwert des Kontaktwiderstands 192 ist in der Regel größer als die Zahlenwerte der Widerstände 191, 193 und 195 der einzelnen Komponenten Spindel 110, Werkzeug 120 und Werkstück 130 und kann bei großem Verschmutzungsgrad den hochohmigen Bereich erreichen, d.h. > 1 kΩ werden.

Schließlich berücksichtigt der Widerstand 194 den Kontakt- bzw. den Übergangswiderstand zwischen dem Werkzeug 120 und dem Werkstück 130. In der in der Fig. 1 gezeigten Anordnung der Werkzeugmaschine 100 hat das Werkzeug 120 keinen Kontakt mit dem Werkstück 130, so dass der Zahlenwert des Widerstands 194 im Wesentlichen unendlich groß ist. Damit hat der Widerstand 190, der sich aus einer Serienschaltung der Widerstände 191, 92, 193, 194 und 195 zusammensetzt im Wesentlichen den Zahlenwert des Kontaktwiderstands 194. Dieser Wert des Widerstands 190 wird im Folgenden, wie bereits im dritten Teil der Beschreibung eingeführt, mit $R_1$ bezeichnet. Der Strom den die Potentialdifferenz der Spannungsquelle 142 erzeugt und der von dem Stromdetektor 144 gemessen ist, ist damit im Wesentlichen, d.h. bis auf eventuell auftretende Leckströme, Null.

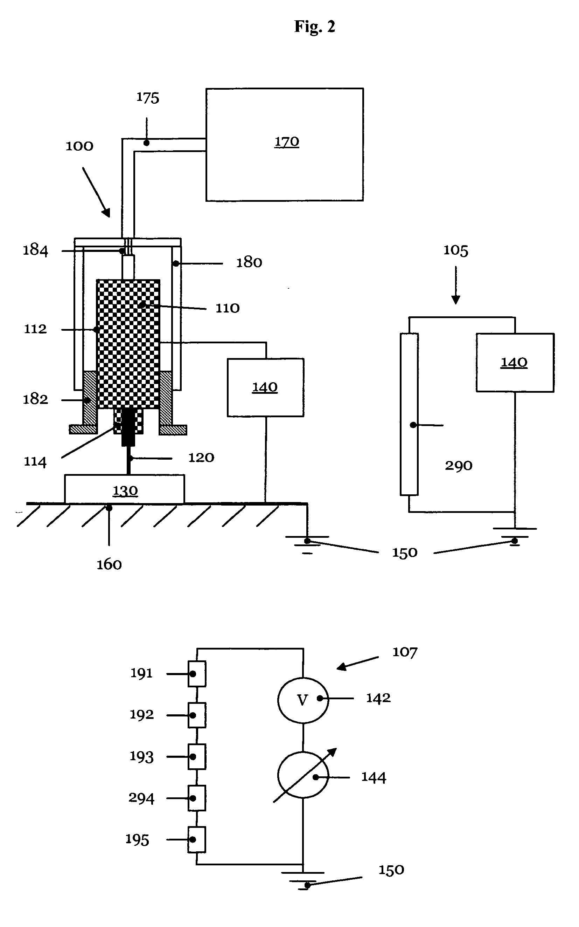

Die Fig. 2 zeigt die Werkzeugmaschine 100 der Fig. 1, bei der das Werkzeug 120 in mechanischen Kontakt mit dem Werkstück 130 gebracht ist. Der Kontaktwiderstand 294 ändert dadurch seinen Zahlenwert von im Wesentlichen unendlich (Widerstand 194 der Fig. 1) auf einen endlichen Widerstandswert. Der Kontaktwiderstand 294 wird von der Kontaktfläche zwischen Werkzeug 120 und Werkstück 130 sowie von der Oberflächengeometrie des Werkzeugs 120 beeinflusst. Ferner kann eine eingesetzte Kühlflüssigkeit einen gewichtigen Einfluss auf die Größe des Widerstands 294 nehmen. Der Zahlenwert des Widerstands kann dadurch über ein breites Werteintervall hinweg schwanken. Dieses Intervall kann von wenigen 12 bis in den kΩ-Bereich hinein reichen.

Der Wert des Widerstands 290 wird nachfolgend mit $R_2$ bezeichnet. Er ist identisch mit dem bereits im dritten Abschnitt eingeführten elektrischen Wi8derstand $R_2$.Er kann mit Hilfe des Stromdetektors 144 des Detektors 140 bei eingeschalteter Spannungsquelle 142 aus der Strommessung ermittelt werden.

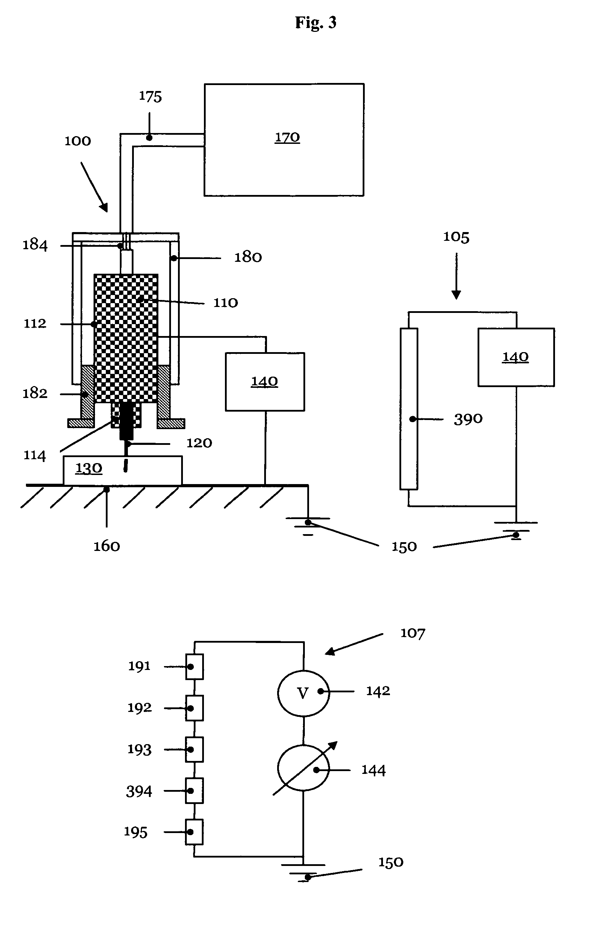

In der Fig. 3 ist die Situation veranschaulicht die in der während eines Bohrvorgangs mit der Werkzeugmaschine 100 das Werkzeug 120, d.h. der Bohrer abbricht. Der Bruch des Werkzeugs 120 ändert den Kontaktwiderstand 394 zwischen Werkzeug 120 und Werkstück 130. In aller Regel verschlechtert ein Bruch des Werkzeugs 120 den Kontakt zu dem Werktisch 130 und führt damit zu einer Vergrößerung des Übergangswiderstands 394 zwischen (defektem) Werkzeug 120 und Werkstück 130. Dies resultiert in einer Erhöhung des Kontaktwiderstands 394 im Vergleich zu der in der Fig. 2 dargestellten Situation (Widerstand 294). Eine ähnliche Situation kann auftreten, wenn nicht das Werkzeug 120 sondern das Werkstück 130 zu Bruch geht. Der Widerstand 394 kann somit abhängig von dem individuell vorliegenden Defekt über einen großen Wertebereich schwanken. Zahlenwert des Widerstands 394 Üblicherweise, d.h. abgesehen von extremen Ausnahmefällen reicht der Zahlenwert des Widerstands 394 vom kΩ- bis in den GΩ-Bereich. Der Widerstand 390 wird für den Rest der Beschreibung mit $R_3$ bezeichnet. Er entspricht dem im dritten Teil der Beschreibung eingeführten Widerstand $R_3$.

Wie bereits oben angesprochen, kann die Gleichstrom- oder Gleichspannungsmessung zum Bestimmen des Widerstands 190, 290, 390 durch hochfrequente Störungen, die von der Werkzeugmaschine 100 oder deren Umgebung erzeugt werden, die Messung des Widerstands 190, 290, 390 erschweren. In den Vorrichtungen zur Analyse des Widerstands zwischen Spindel 110 und Werkstück 130 ist die Spindel 110 Teil des Signalpfades des Messsignals. Die Spindel 110 weist ruhende Teile (z.B. das Spindelgehäuse 112) und rotierende Teile (beispielsweise die Werkzeugaufnahme 114). Damit werden die von ihr erzeugten Störsignale ungefiltert dem Messsignal überlagert. Es hat sich deshalb als zweckmäßig erwiesen, in den Detektor 140 ein Tiefpassfilter einzusetzen, um die dem Messsignal überlagerten hochfrequenten Störungen weitgehend zu unterdrücken (in den Figuren 1 - 3 nicht gezeigt).

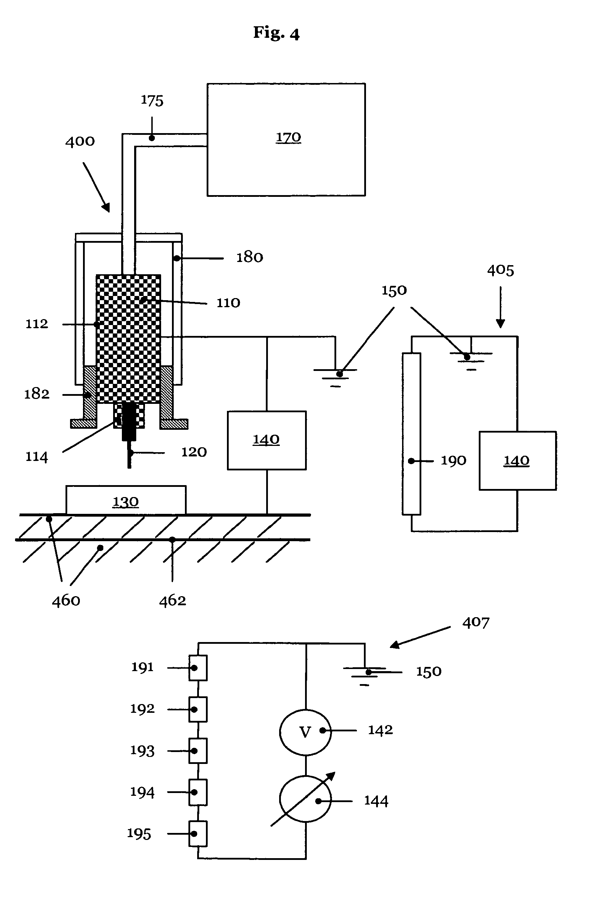

Die Messung des Widerstands 190, 290 und 390 mit dem Detektor 140 erfordert das Auftrennen der elektrischen Masse 150 der Werkzeugmaschine 100 an einer der beiden Messpositionen. In den Figuren 1 bis 3 ist das Gehäuse 112 der Spindel 110 der Werkzeugmaschine 100 von der elektrischen Masse 150 getrennt. Diese Trennung kann jedoch auch an der zweiten Messposition erfolgen. Diese Ausführungsform ist in dem linken oberen Teilbild der Fig. 4 veranschaulicht. In den Werktisch 460 der Werkzeugmaschine 400 ist eine elektrisch isolierende Schicht 462 eingefügt. Damit wird der obere Teil des Werktisches 460 elektrisch von der Maschinenmasse 150 getrennt. In dieser Ausführungsform kann auf das Abtrennen des Spindelgehäuses 112 von der Maschinenmasse 150 verzichtet werden. Das rechte obere Teilbild der Fig. 4 repräsentiert das elektrische Ersatzbild 405 dieser Ausführungsform der Vorrichtung zur Widerstandsmessung. Das Ausführungsbeispiel 407 der unteren Teilbild der Fig. 4 zeigt das Ausführungsbeispiel 107 der Fig. 1 bei der der Masseanschluss 150 an die andere Anschlussklemme verschoben ist.

In einer besonders einfachen Ausführungsform bleibt die Werkzeugmaschine 100, 400 selber unverändert. Es wird vielmehr einfach das Werkstück 130 von dem Werktisch 160 durch eine isolierende Unterlage elektrisch von der Maschinenmasse 150 getrennt und direkt mit einem Anschluss des Detektors 140 verbunden (nicht in einer der Figuren dargestellt). Diese Ausführungsform verringert den Integrationsaufwand einer Ausführungsform der Vorrichtung in die Maschine auf ein Minimum und eignet sich daher besonders zur Nachrüstung bereits im Einsatz befindlicher Anlagen.

In einer weiteren einfachen Ausführungsform wird die Maschinenmasse 150 der Werkzeugmaschine 100, 400 gegenüber ihrem Ausgangszustand nicht verändert. Die Auftrennung der elektrischen Masse zum Messen des Widerstands 190, 290, 390 erfolgt durch eine Werkzeugspannvorrichtung, mit der das Werkstück 130 elektrisch isoliert gespannt werden kann. Diese Ausführungsform ist zumindest in zwei Varianten realisierbar. Zum einen können die Spannbacken und Spannpratzen gegen die anderen Teile der Spannvorrichtung isoliert werden. Diese Variante einer isolierenden Werkzeugspannvorrichtung zum Messen des Widerstands 190, 290, 390 zwischen Spindel 110 und Werkstück 130 mit minimalem Aufwand in eine Werkzeugmaschine integriert werden. Zum anderen kann die Werkzeugspannvorrichtung durch eine elektrisch isolierende Platte und elektrisch isolierende Gewindehülsen von dem Werktisch 160 der Werkzeugmaschine 100, 400 elektrisch getrennt werden. Diese Variante kann Umbaumaßnahmen auf Seite der Werkzeugmaschine 100, 400 erfordern.

Es ist ferner denkbar zum Einbau eines Detektors 140 beide Anschlussklemmen von der Maschinenmasse 150 zu trennen, d.h. die Ausführungsformen der Werkzeugmaschinen 100 und 400 zu kombinieren.

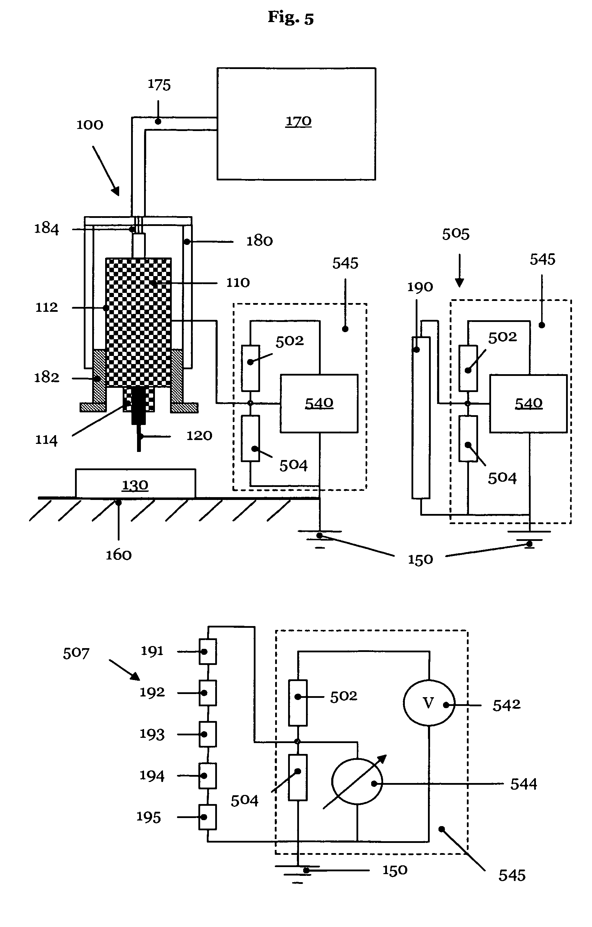

Die Fig. 5 zeigt im linken oberen Teilbild die Werkzeugmaschine 100 der Fig. 1 bei der der Detektor 140 durch einen modifizierten Widerstandsdetektor 540 und einen Spannungsteiler ersetzt ist. Der Detektor 545 umfasst somit den Spannungsteiler der Widerstände 502 und 504 sowie den Detektor 540 für die Widerstandsmessung. Im rechten oberen Teilbild ist das elektrische Ersatzschaltbild 505 dargestellt und das untere Teilbild repräsentiert ein Ausführungsbeispiel 507 des Detektors 545.

Der Spannungsteiler umfasst zwei Widerstände 502 und 504. In der in Fig. 5 angegebenen Ausführungsform erzeugt eine Spannungsquelle 542 eine Potentialdifferenz, die an den Spannungsteiler gelegt wird. Die oben gemachten Ausführungen zu der Spannungsquelle 142 der Figuren 1 - 4 gelten analog für die Spannungsquelle 542. Der Widerstand 502 des Spannungsteilers liegt beispielsweise im einstelligen $k\Omega$-Bereich und dient gleichzeitig als Strombegrenzer im Falle eines Kurzschlusses des Widerstands 190. Der Widerstandswert des zweiten Widerstands 504 des Spannungsteilers wird an den Widerstand 190 zwischen Spindel 110 und Werktisch 130 angepasst. In einer beispielhaften Ausführung des Spannungsteilers liegt der Zahlenwert des Widerstands 504 im Bereich von 100 $\Omega$. Der Mittenabgriff des Spannungsteilers wird an das Spindelgehäuse 112 der Spindel 110 und damit an einen Anschluss des Widerstands 190 gelegt. Über den Mittenabgriff des Spannungsteilers ermittelt der Spannungsdetektor 544 den Wert und den zeitlichen Verlauf des Widerstands 190.

Anstelle der Spannungsquelle 542 kann in dem Detektor 545 eine Stromquelle verwendet werden. Der Alarmgenerator ist in dem Detektor 545 der Fig. 5 wiederum nicht dargestellt.

In dem in der Fig. 5 dargestellten Beispiel ist der Detektor 545 in die Werkzeugmaschine 100 der Fig. 1 integriert. In einer anderen Ausführungsform kann der Detektor 545 in die Werkzeugmaschine 400 der Fig. 4 eingebaut werden.

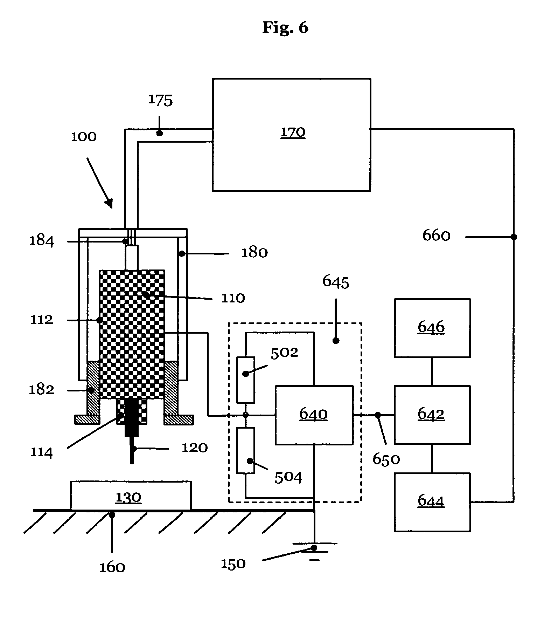

Die Fig. 6 reproduziert die Werkzeugmaschine 100 mit einem Detektor 645, der wiederum einen Spannungsteiler umfasst. Der Detektor 645 ist über die Verbindung 650 an das Überwachungssystem 642 der Werkzeugmaschine 100, 400 angeschlossen. Das Überwachungssystem 642 ist seinerseits mit der NC- (numerical control) Steuerung 644 der Werkzeugmaschine 100, 400 verbunden. Zudem ist die NC-Steuerung 644 über die Verbindung 660 mit dem Umrichter 170 der Werkzeugmaschine 100, 400 verbunden. Damit kann das Überwachungssystem 642 über die NC-Steuerung 644 den Umrichter 170 der Werkzeugmaschine 100, 400 abschalten und damit den Vorschub der Spindel 110 und bei Bedarf die Rotation des Werkzeugs 120 stoppen.

Der Detektor 645 überträgt die während des Betriebs gemessenen zeitlichen Verläufe der Zahlenwerte der Widerstände 190, 290 und 390 über die Übertragungsstrecke 650 an das Überwachungssystem 642. Die Übertragung 650 kann drahtgebunden oder drahtlos erfolgen. Die Messdaten können in analoger oder digitaler Form von dem Detektor 645 an das Überwachungssystem 642 übertragen werden.

Die Datenübertragung muss nicht auf eine Richtung beschränkt sein. Vielmehr kann die Verbindung 650 zwischen dem Detektor 645 und dem Überwachungssystem 642 zur Kontrolle des Detektors 645 durch das Überwachungssystem 642 benutzt werden.

Darüber hinaus ist das Überwachungssystem 642 mit einem Bildschirm 646 verbunden, der neben anderen Kenngrößen der Maschine auch die graphische Darstellung gemessener Widerstandsverläufe der Widerstände 190, 290 und 390 ermöglicht.

Mit der in der Fig. 6 dargestellten Vorrichtung konnte der Betrieb einer Werkzeugmaschine 100, 400, in deren Spindelwerkzeugaufnahme 114 ein 0,35 mm Bohrer eingesetzt war, erfolgreich überwacht werden. Der Betrieb einer Werkzeugmaschine 100, 400 bedeutet hier wie im Folgenden das in Gang setzen und Stoppen der Drehbewegung des Werkzeugs 120 und das kontrollierte Ändern des Abstands zwischen der Spindel 110 und dem Werkstück 130, d.h. das Ein- bzw. Ausschalten eines definierten Vorschubs der Spindel 110 und/oder des Werktisches 130.

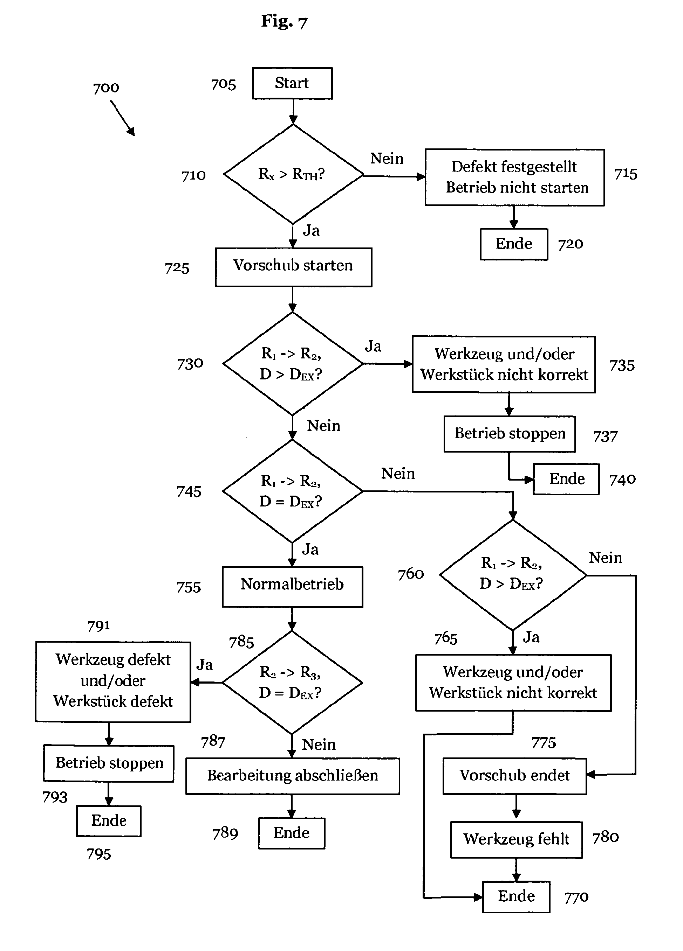

Die Fig. 7 veranschaulicht schematisch das Ablaufdiagramm einer beispielhaften Ausführungsform des erfindungsgemäßen Verfahrens 700. Dieses Ausführungsbeispiel basiert auf einer Anordnung, bei der der Detektor 645 seine Messdaten an das Überwachungssystem 642 übermittelt und dieses die Werkzeugmaschine 100, 400 regelt.

Das Verfahren 700 beginnt bei Schritt 705. In der Ausgangssituation ist, wie in den Figuren 1, 4, 5 und 6 veranschaulicht, das Werkzeug 120 nicht in Kontakt mit dem Werkstück 130. Dadurch ist, wie bereits oben ausgeführt, der Widerstand 190 im Wesentlichen unendlich groß ist. Ferner ist in der Startposition die Drehbewegung des Werkzeugs 120 nicht angeschaltet.

Bei Entscheidungsblock 710 wird der Widerstand 190, 290, 390, der im Folgenden mit $R_x$ bezeichnet wird, abgefragt. Falls bei der Abfrage festgestellt wird, dass der numerische Wert des Widerstands $R_x$ einen vorgegebenen Schwellenwert $R_{TH}$ nicht überschreitet, wird angenommen, dass eine Störung der Werkzeugmaschine 100, 400, wie etwa ein Kurzschluss vorliegt. Dieser Defekt wird über das Display oder den Bildschirm 646 dem Nutzer angezeigt und der Betrieb der Werkzeugmaschine 100, 400, d.h. das Einschalten der Rotation des Werkzeugs 120 und des Vorschubs, durch den der Abstand zwischen Werkzeug 120 und Werkstück 130 in definierter Weise verringert wird, wird nicht gestartet. Vielmehr endet das Verfahren bei Schritt 720.

Wenn bei Entscheidungsblock 710 bestimmt wird, dass der gemessene Widerstand $R_x$ größer als der Schwellenwert $R_{TH}$ ist, startet die Steuerung 644 bei Schritt 725 den Betrieb der Maschine 100, 400 durch Anschalten der Rotation des Werkzeugs 120 und des Vorschubs.

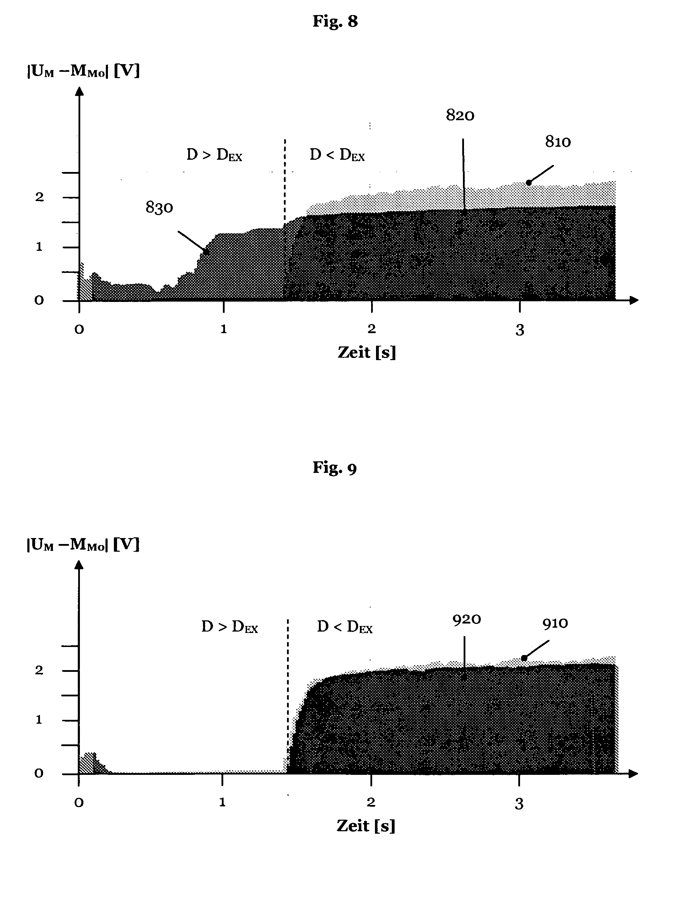

In dem Überwachungssystem 642 sind die Daten abgelegt, bei welchem Abstand zwischen der Spindel 110 und dem Werkstück 130 in Abhängigkeit von dem zur Bearbeitung des Werkstücks 130 verwendeten Werkzeugs 120 ein mechanischer Kontakt zwischen diesen beiden Komponenten 120 und 130 auftreten sollte. Dieser Wert ist in der Fig. 8 als $D_{EX}$ angedeutet. An dieser Stelle wird erwartet, dass der Widerstand $R_x$ seinen Zahlenwert von $R_1$ in $R_2$ ändert, da der Kontaktwiderstand 194 (Fig. 1) von im Wesentlichen unendlich in den Widerstand 294 mit einem endlichen Zahlenwert übergeht. Alternativ und/oder zusätzlich zu der Ablage der $D_{EX}$ Daten in einem Speicher der Werkzeugmaschine 100, 400 kann der Abstand D zwischen Spindel 110 und Werkstück 130 kontinuierlich oder periodisch gemessen werden.

Wenn bei Entscheidungsblock 730 der Fig. 7 festgestellt wird, dass der Übergang des Widerstands $R_x$ von $R_1$ nach $R_2$ bei einem Abstand D zwischen Spindel 110 und Werkstück 130 auftritt, der größer als die erwartete Distanz $D_{EX}$ ist, zeigt das Display 646 des Überwachungssystem 642 bei Block 735 dem Nutzer an, dass entweder das Werkstück 130 oder das Werkzeug 120 nicht korrekt ist. Ein Beispiel eines nicht richtigen Werkzeugs liegt beispielsweise vor, wenn in der Aufnahme 114 der Spindel 110 irrtümlicherweise ein Fräser anstelle eines Bohrers eingespannt ist oder wenn der eingespannte Bohrer die falsche Länge aufweist. Ein defektes Werkstück 130 kann zum Beispiel ein Werkstück sein, das nicht richtig relativ zu dem Werkzeug 120 positioniert ist oder falls der Werktisch 160 ein Werkstück 130 mit zu großer Dicke aufweist.

Um den Schaden an dem Werkstück 130 und die Folgekosten einer falschen Bearbeitung zu minimieren, wird bei Vorliegen der Bedingung des Entscheidungsblocks 730 bei Schritt 737 der Betrieb der Maschine 100, 400 gestoppt und das Verfahren endet bei Schritt 740.

Die Fig. 8 zeigt schematisch eine Darstellung des Verlaufs einer Spannungsmessung an dem Mittenabgriff des Spannungsteilers der Fig. 5 bei einer Messung des Widerstands $R_x$. Für eine angelegte Spannung U ist die mit dem Spannungsdetektor 544 gemessene Spannung UM gegeben durch:

$$U_M = \frac{\dfrac{R_2 \cdot R_x}{R_2 + R_x}}{R_1 + \dfrac{R_2 \cdot R_x}{R_2 + R_x}} \cdot U \qquad (1)$$

wobei $R_1$ dem Widerstand 502 und $R_2$ dem Widerstand 504 der Fig. 5 entspricht. Für $R_x \to \infty$ d.h. $R_x = R_1$ reduziert sich die Gleichung (1) auf:

$$U_{M0} = \frac{R_2}{R_1 + R_2} \cdot U \qquad (2)$$

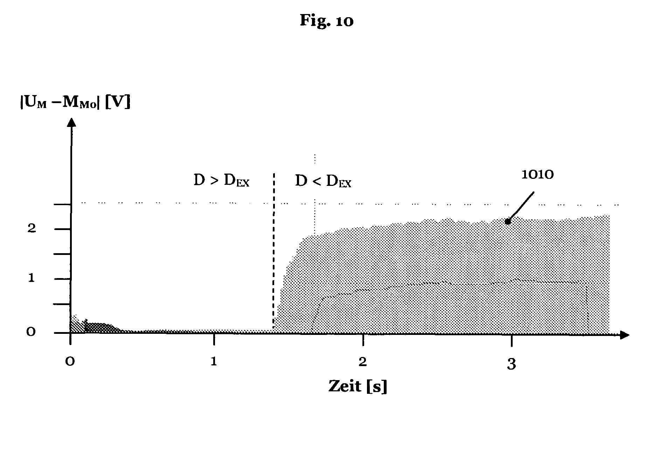

In der Fig. 8 (wie auch in den nachfolgenden Figuren 9 und 10) ist der Absolutbetrag der Spannung UM bezogen auf die Situation in der der Widerstand 191 zwischen Spindel 110 und Werkstück 130 unendlich ist ($R_x = R_1$), d.h. $|U_M - U_{M0}|$ über der Zeit aufgetragen, in der der Vorschub eingeschaltet ist. In dieser Darstellung bedeutet ein Anwachsen der dargestellten Spannungsdifferenz ein Absinken der Spannung an dem Mittenabgriff des Spannungsteilers hervorgerufen durch eine Verringerung des Widerstands 190 oder des Widerstands $R_x$. Bei dieser Art der Auftragung sollte bei dem Abstand $D_{EX}$ ein Übergang von einer Spannung Null zu einem Signalwert innerhalb des Flächengrenzwerts 810 stattfinden.

Die hellgraue Fläche 810 zeigt den erwarteten Flächengrenzwert 810 der Spannung $|U_M - U_{M0}|$ bei korrektem Werkzeug 120 und Werkstück 130. Die schwarze Kurve zeigt den gemessenen Spannungsverlauf für den Bereich in dem ein mechanischer Kontakt zwischen Werkzeug 120 und Werkstück 130 erwartet wird, d.h. für $D < D_{EX}$. Zu Beginn dieses Intervalls wird der Übergang von $R_1$ nach $R_2$ erwartet. Die schwarze Fläche 820 stellt einen normalen Betrieb der Werkzeugmaschine 100, 400 dar; die Darstellung der Spannung $|U_M - U_{M0}|$ durch die Fläche 820 bleibt über den gesamten Bearbeitungsprozess hinweg (d.h. $D < D_{EX}$) unterhalb des Flächengrenzwertes 810. Die Fig. 8 zeigt, dass die gemessene Spannung UM und damit der Widerstand $R_2$ während des Bearbeitungsvorgangs im Wesentlichen konstant sind.

Der mittelgraue Bereich 830 illustriert, dass bereits in dem Abstandsintervall $D > D_{EX}$ der Übergang von $R_1$ nach $R_2$ stattfindet. Im Detail zeigt der linke Teil des mittelgrauen Bereichs 830 die Kontaktierung zwischen Werkzeug 120 und Werkstück 130, die durch Aufbringen von Spänen auf die Oberfläche des Werkstücks 130 bewusst hervorgerufen wurde. In dem Abstandsbereich ist der Zahlenwert des Widerstands $R_x$ zwischen Spindel 110 und Werkstück noch im hochohmigen Bereich und unterliegt zudem einer deutlichen Schwankung.

Der rechte Teil des Bereichs 830 veranschaulicht die mit dem Materialanschnitt des Werkstücks 130 einhergehende Änderung des Widerstands $R_x$. Nach einem steilen Absinken des Widerstands $R_x$ erricht dieser das Niveau von $R_2$ bereits in dem Bereich $D > D_{EX}$. Dies bedeutet, die Fig. 8 zeigt ein Werkstück 130, dessen Höhe zu groß ist.

Die Fig. 8 veranschaulicht einen Ausschnitt des in der Fig. 7 erläuterten Beispiels des erfindungsgemäßen Verfahrens. Aus diesem Grund wurde der Betrieb der Maschine 100,400 nach dem Detektieren des Übergangs von $R_1$ nach $R_2$ in dem Abstandsintervall $D > D_{EX}$ nicht unterbrochen.

Wieder mit Bezug auf die Fig. 7, wird bei Entscheidungsblock 745 ermittelt, ob der Übergang von $R_1$ nach $R_2$ bei dem erwarteten Abstand zwischen Spindel 110 und Werkzeug 130 auftritt. Falls dies zutrifft, arbeitet die Werkzeugmaschine 100, 400 im normalen Betriebsmodus, wie dies in dem Block 755 der Fig. 7 angedeutet ist.

Die Fig. 9 illustriert eine Darstellung des Verlaufs der Messung des Widerstands $R_x$ während eines normalen Bearbeitungsprozesses. Wie in der Fig. 8 ist als Ordinate der Absolutbetrag der Spannungsdifferenz von UM und $U_{Mo}$ über der Zeit des eingeschalteten Vorschubs dargestellt. In dem Abstandsintervall $D > D_{EX}$ weist $R_x$ den Wert $R_1$ auf (UM = $U_{Mo}$). Bei $D_{EX}$ erfolgt erwartungsgemäß der Übergang von $R_1$ nach $R_2$. In dem Bereich $D < D_{EX}$ bleibt die Messgröße $|U_M - U_{M0}|$ 920 immer unterhalb des vorgegebenen Flächengrenzwerts 910.

Wieder mit Bezug auf die Fig. 7, für den Fall, dass der Übergang von $R_1$ nach $R_2$ nicht bei $D_{EX}$ detektiert wird, wird bei Entscheidungsblock 760 ermittelt, ob der Übergang in dem Abstandsintervall $D < D_{EX}$ bestimmt werden kann. Falls dies nicht der Fall ist, endet der Vorschub bei Schritt 775 nach Ablauf des vorgegebenen Vorschubintervalls und das Display 646 zeigt bei Schritt 780 an, dass das Werkzeug 120 fehlt und das Verfahren endet bei Schritt 770.

Diese Situation ist in der Fig. 10 veranschaulicht. Die graue Fläche 1010 gibt wiederum den Flächengrenzwert für den Widerstand $R_x$ an, wobei die Messgröße wie in den Figuren 8 und 9 wiederum durch $|U_M - U_{M0}|$ gegeben ist. Wie die Fig. 10 zeigt, findet innerhalb des gesamten Bearbeitungsintervalls $D < D_{EX}$ kein Übergang von $R_1$ nach $R_2$ statt. Über die gesamte Vorschubdistanz bleibt UM auf dem Spannungsniveau von $U_{Mo}$. Neben dem Fehlen des Werkzeugs 120 kann der Verlauf, der in der Fig. 10 dargestellten Widerstandsmessung auf das Fehlen des Werkstücks 130 hinweisen.

Wieder mit Bezug auf das in der Fig. 7 dargestellte beispielhafte Verfahren, falls bei Entscheidungsblock 760 festgestellt wird, dass der Übergang von $R_1$ nach $R_2$ in dem Abstandsintervall $D < D_{EX}$ erfolgt, so zeigt dies, dass entweder das Werkzeug 120 oder das Werkstück 130 nicht korrekt sind. Mögliche Gründe für eine derartige Situation könnten sein: Das Werkzeug 120 ist zu kurz oder ein falscher Werkzeugtyp ist in der Aufnahme 114 der Spindel 110 vorhanden. Ein falsches Werkstück 130 wird verwendet oder das richtige Werkstück 130 ist falsch positioniert. Der Defekt wird dem Nutzer der Maschine 100, 400 bei Schritt 765 über das Display 646 visualisiert und das Verfahren endet bei Schritt 770.

Während des Normalbetriebs wird bei Entscheidungsblock 785 bestimmt, ob ein Übergang von dem Widerstand $R_2$ zu $R_3$ erfolgt. Falls dies nicht der Fall ist, wird die Bearbeitung des Werkstücks bei Block 787 abgeschlossen und das Verfahren endet bei Schritt 789. Wenn eine Änderung den Widerstands $R_x$ von $R_2$ zu $R_3$ detektiert wird, wird dem Nutzer über den Monitor 646 der Maschine 100, 400 bei Schritt 791 angezeigt, dass das Werkzeug 120 und/oder das Werkstück 130 defekt sind. Bei Block 793 stoppt das Überwachungssystem 642 über die Steuerung 644 durch Abschalten des Umrichters 170 den Betrieb der Werkzeugmaschine 100, 400 und das Verfahren endet bei Schritt 795.

Das erfindungsgemäße Verfahren ermöglicht somit ein kostengünstiges Überwachen des Betriebs einer Werkzeugmaschine, ohne deren Bearbeitungszeit und damit deren Durchsatz zu beeinträchtigen.

**Patentansprüche**

1. Vorrichtung zum Überwachen des Betriebs eines elektrisch leitfähigen Werkzeugs (120) einer Werkzeugmaschine (100, 400), aufweisend:

   a. zumindest eine elektrisch leitfähige Spindel (110) zur Aufnahme des Werkzeugs (120);
   b. einen Detektor (140 545, 645) der einen elektrischen Widerstand (190, 290, 390) zwischen der Spindel (110) und einem zu bearbeitenden, elektrisch leitfähigen Werkstück (130) bestimmt; wobei
   c. die Spindel (110) von der Werkzeugmaschine (100, 400) elektrisch isoliert ist und/oder die Vorrichtung ausgebildet, um das zu bearbeitende Werkstück (130) elektrisch von der Werkzeugmaschine (100, 400) zu isolieren;

   **dadurch gekennzeichnet, dass** die Vorrichtung ferner

   d. einen Spannungsteiler aufweist ; der zumindest zwei Widerstände (502, 504) umfasst, wobei ein Mittenabgriff des Spannungsteilers elektrisch leitfähig mit der Spindel (110) und dem Detektor (540, 640) verbunden ist und wobei ein Ende des Spannungsteilers elektrisch leitfähig mit dem Werkstück (130) verbunden ist.

2. Vorrichtung nach einem der vorhergehenden Ansprüche, wobei der Detektor (140, 540, 545, 640, 645) ausgestaltet ist, einen Alarm zu erzeugen.

3. Vorrichtung nach einem der vorhergehenden Ansprüche, wobei das Werkstück (130) auf einem elektrisch leitfähigen Werktisch (160) der Werkzeugmaschine (100, 400) angeordnet ist und der Detektor (140, 545, 645) elektrisch leitend mit dem Werktisch (160) verbunden ist.

4. Vorrichtung nach einem der Ansprüche 1 oder 2, wobei das Werkstück (130) auf einem elektrisch isolierenden Werktisch (460) der Werkzeugmaschine (100, 400) angeordnet oder der elektrisch leitfähige Werktisch (460) elektrisch von der Werkzeugmaschine (100, 400) isoliert ist und der Detektor (140, 545, 645) elektrisch leitend mit dem zu bearbeitenden, elektrisch leitfähigen Werkstück (130) oder mit dem elektrisch von der Werkzeugmaschine (100, 400) isolierten, elektrisch leitfähigen Werktisch (460) verbunden ist.

5. Vorrichtung nach einem der Ansprüche 1 oder 2, weiterhin aufweisend eine Werkstückspannvorrichtung, die ausgebildet ist das Werkstück (130) elektrisch isoliert von der Werkzeugmaschine (100, 400) zu spannen.

6. Vorrichtung nach einem der vorhergehenden Ansprüche, wobei der Detektor (140) einen Stromdetektor (144) und eine Spannungsquelle (142) umfasst oder der Detektor (545, 645) eine Spannungsquelle (542) oder eine Stromquelle und einen Spannungsdetektor (544) umfasst.

7. Vorrichtung nach einem der vorhergehenden Ansprüche, wobei der Detektor (140, 545, 645) ausgebildet ist, um festzustellen, dass die Spindel (110), das Werkzeug (120) und das Werkstück (130)

   - einen ersten elektrischen Widerstand (190) bilden, wenn das Werkzeug (120) nicht mit dem Werkstück (130) in Kontakt ist oder kein Werkzeug (120) oder Werkstück (130) vorhanden ist,
   - einen zweiten elektrischen Widerstand (290) bilden, wenn das Werkzeug (120) mit dem Werkstück (130) in Kontakt ist, oder
   - einen dritten elektrischen Widerstand (390) bilden, wenn das Werkzeug (120) mit dem Werkstück (130) in Kontakt ist und das Werkzeug (120) und/oder das Werkstück (130) defekt sind.

8. Vorrichtung nach Anspruch 7, wobei der Detektor (645) ferner ausgebildet ist, um festzustellen, dass

   a. ein nicht korrektes Werkzeug (120) oder ein nicht korrektes Werkstück (130) vorliegt, wenn ein Übergang von dem ersten elektrischen Widerstand zu dem zweiten elektrischen Widerstand bei einem Abstand zwischen Spindel (110) und Werkstück (130) auftritt, der größer als ein vorgegebener Abstand ist und / oder
   b. ein korrekter Betrieb der Werkzeugmaschine (100, 400) vorliegt, wenn der Übergang von dem ersten elektrischen Widerstand zu dem zweiten elektrischen Widerstand innerhalb eines vorgegebenen Abstandsintervalls zwischen Spindel (110) und Werkstück (130) auftritt und / oder
   c. das Werkzeug (120) fehlt, wenn kein Übergang von dem ersten zu dem zweiten elektrischen Widerstand innerhalb eines vorgegebenen Abstandsintervalls zwischen Spindel (110) und Werkstück (130) auftritt und /oder
   d. ein nicht korrektes Werkzeug (120) oder ein nicht korrektes Werkstück (130) vorliegt, wenn ein Übergang von dem ersten elektrischen Widerstand zu dem zweiten elektrischen Widerstand bei einem Abstand zwischen Spindel (110) und Werkstück (130) auftritt, der kleiner als ein vorgegebener Abstand ist.

9. Vorrichtung nach Anspruch 8, wobei der Detektor (645) ferner ausgebildet ist, um festzustellen, dass ein defektes Werkzeug (120) oder ein defektes Werkstück (130) vorliegt, wenn ein Übergang von dem zweiten elektrischen Widerstand zu dem dritten elektrischen Widerstand auftritt.

10. Vorrichtung nach der Ansprüch 8 oder 9, wobei der Detektor (645) ausgebildet ist, um zu überwachen, dass der Verlauf des elektrischen Widerstands beim Bearbeiten des Werkstücks (130) im Wesentlichen einem vorgegebenen Verlauf folgt.

11. Vorrichtung nach Anspruch 10, wobei der Verlauf des elektrischen Widerstands beim Bearbeiten des Werkstücks (130) unterhalb einer ersten vorgegebenen Hüllkurve und oberhalb einer zweiten vorgegebenen Hüllkurve liegt oder innerhalb vorgegebener Flächenwerte liegt.

12. Vorrichtung nach einem der vorhergehenden Ansprüche, wobei der Detektor (645) mit einem Überwachungssystem (642) der Werkzeugmaschine (100, 400) verbunden ist, und wobei das Überwachungssystem (642) ausgestaltet ist, den Betrieb der Werkzeugmaschine (100, 400) zu unterbrechen.

13. Verfahren zum Überwachen einer Werkzeugmaschine (100, 400) mit einer elektrisch leitfähigen Spindel (110) beim Bearbeiten eines elektrisch leitfähigen Werkstücks (130), wobei die Spindel (110) ein elektrisch leitfähiges Werkzeug (120) aufnimmt und wobei die Spindel (110) und/oder das Werkstück (130) elektrisch von der Werkzeugmaschine (100, 400) isoliert ist, das Verfahren aufweisend den Schritt des

Bestimmens einer Änderung des elektrischen Widerstands zwischen der Spindel (110) und dem Werkstück (130), **dadurch gekennzeichnet, dass** ein Spannungsteiler, zumindest zwei Widerstände (502, 504) umfasst, wobei ein Mittenabgriff des Spannungsteilers elektrisch leitfähig mit der Spindel (110) und dem Detektor (540, 640) verbunden ist und wobei ein Ende des Spannungsteilers elektrisch leitfähig mit dem Werkstück (130) verbunden ist.

## Claims

1. An apparatus for monitoring the operation of an electrically conductive tool (120) of a machine tool (100, 400), comprising:

   a. at least one electrically conductive spindle (110) for holding the tool (120);
   b. a detector (140, 545, 645) determining an electrical resistance (190, 290, 390) between the spindle (110) and an electrically conductive work piece (130) to be processed, wherein
   c. the spindle (110) is electrically isolated from the machine tool (100, 400) and / or the apparatus is adapted to electrically isolate the work piece (130) to be processed from the machine tool (100, 400),

   **characterized in that**

   d. the apparatus further comprises a voltage divider which comprises at least two resistances (502, 504), wherein a center tap of the voltage divider is conductively connected with the spindle (110), and the detector (540, 640) and wherein one end of the voltage divider is conductively connected with the work piece (130).

2. The apparatus according to any one of the proceeding claims, wherein the detector (140, 540, 545, 640, 645) is operable to generate an alarm.

3. The apparatus according to any one of the proceeding claims, wherein the work piece (130) is arranged on an electrically conductive work bench (160) of the machine tool (100, 400) and the detector (140, 540, 545, 645) is conductively connected with the work bench (160).

4. The apparatus according to one of the claims 1 to 2, wherein the work piece (130) is arranged on an electrically isolating work bench (460) of the machine tool (100, 400), or the electrically conductive work bench (460) is electrically isolated from the machine tool (100, 400) and the detector (140, 545, 645) is conductively connected with the electrically conductive work piece (130) to be processed or with the electrically conductive work bench (460) which is electrically isolated from the machine tool (100, 400).

5. The apparatus according to one of the claims 1 to 2, further comprising a work piece clamping device which is adapted to clamp the work piece (130) in such a way that it is electrically isolated from the machine tool (100, 400).

6. The apparatus according to any one of the proceeding claims, wherein the detector (140) comprises a current meter (144) and a voltage source (142), or the detector (545, 645) comprises a voltage source (542) or a current source and a voltage detector (544).

7. The apparatus according to any one of the proceeding claims, wherein the detector (140, 545, 645) is operable to detect that the spindle (110), the tool (120) and the work piece (130)

   - lead to a first electrical resistance (190) if the tool (120) is not in contact with the work piece (130), or if there is no tool (120) or no work piece (130) present,
   - lead to a second electrical resistance (290) if the tool (120) is in contact with the work piece (130), or
   - lead to a third electrical resistance (390) if the tool (120) is in contact with the work piece (130) and the tool (120) and / or the work piece (130) are defective.

8. The apparatus according to claim 7, wherein the detector is further operable to detect,

   a. that there is an incorrect tool (120) or an incorrect work piece (130) if a transition from the first electrical resistance to the second electrical resistance is found at a distance between the spindle (110) and the work piece (130) which is larger than a predetermined distance and / or

b. that there is a correct operation of the machine tool (100, 400) if the transition from the first electrical resistance to the second electrical resistance is found within a predetermined distance interval between the spindle (110) and the work piece (130) and / or

c. that the tool (120) is missing if no transition is found from the first electrical resistance to the second electrical resistance within a predetermined distance interval between the spindle (110) and the work piece (130) and / or

d. that there is an incorrect tool (120) or an incorrect work piece (130) if a transition from the first electrical resistance to the second electrical resistance is found at a distance between the spindle (110) and the work piece (130) which is smaller than a predetermined distance.

9. The apparatus according to claim 8, wherein the detector (645) is further operable to determine that there is a defective tool (120) or a defective work piece (130) if a transition is found from the second electrical resistance to the third electrical resistance.

10. The apparatus according to claim 8 or 9, wherein the detector is operable to monitor that the behavior of the electrical resistance essentially follows a predetermined behavior when processing the work piece (130).

11. The apparatus according to claim 10, wherein the behavior of the electrical resistance is below a first predetermined envelope and above a second predetermined envelope or is within predetermined area threshold values when processing the work piece (130).

12. The apparatus according to any one of the preceding claims, wherein the detector (645) is connected to a monitoring system (642) of the machine tool (100, 400), and wherein the monitoring system (642) is operable to interrupt the operation of the machine tool (100, 400).

13. A method for monitoring a machine tool (100, 400) having an electrically conductive spindle (110) when an electrically conductive work piece (130) is processed, wherein the spindle (110) holds an electrically conductive tool (120), and wherein the spindle (110) and / or the work piece (130) is electrically isolated from the machine tool (100, 400), the method comprising the step of

determining a variation of the electrical resistance between the spindle (110) and the work piece (130),

**characterized in that**

a voltage divider comprises at least two resistances (502, 504), wherein a center tap of the voltage divider is conductively connected with the spindle (110) and the detector (540, 640), and wherein one end of the voltage divider is conductively connected with the work piece (130).

**Revendications**

1. Dispositif de surveillance du fonctionnement d'un outil (120) électriquement conducteur d'une machine-outil (100, 400), qui présente :

   a. au moins une broche (110) électriquement conductrice pour la réception de l'outil (120) ;

   b. un détecteur (140, 545, 645) qui détermine une résistance électrique (190, 290, 390) entre la broche (110) et une pièce (130) électriquement conductrice à usiner ;

   c. la broche (110) étant électriquement isolée de la machine-outil (100, 400) et/ou le dispositif étant conçu pour isoler électriquement la pièce (130) à usiner de la machine-outil (100, 400) ;

   **caractérisé en ce que** le dispositif présente également

   d. un diviseur de tension qui comprend au moins deux résistances (502, 504), une prise médiane du diviseur de tension étant reliée de manière électriquement conductrice à la broche (110) et au détecteur (540, 640), et une extrémité du diviseur de tension étant reliée de manière électriquement conductrice à la pièce (130).

2. Dispositif selon une des revendications précédentes, dans lequel le détecteur (140, 540, 545, 640, 645) est conçu pour générer une alarme.

3. Dispositif selon une des revendications précédentes, dans lequel la pièce (130) est disposée sur une table porte-pièce (160) électriquement conductrice de la machine-outil (100, 400), et le détecteur (140, 545, 645) est relié de manière électriquement conductrice à la table porte-pièce (160).

4. Dispositif selon une des revendications 1 ou 2, dans lequel la pièce (130) est disposée sur une table porte-pièce (460) électriquement isolante de la machine-outil (100, 400) ou la table porte-pièce (460) électriquement conductrice est électriquement isolée de la machine-outil (100, 400) et le détecteur (140, 545, 645) est relié de manière électriquement conductrice à la pièce (130) électriquement conductrice à usiner ou à la table porte-pièce (460) électriquement conductrice qui est électriquement isolée de la machine-outil (100, 400).

5. Dispositif selon une des revendications 1 ou 2, qui présente en outre un dispositif de serrage de pièce conçu pour serrer la pièce (130) de manière électriquement isolée de la machine-outil (100, 400).

6. Dispositif selon une des revendications précédentes, dans lequel le détecteur (140) comprend un détecteur de courant (144) et une source de tension (142), ou le détecteur (545, 645) comprend une source de tension (542) ou une source de courant et un détecteur de tension (544).

7. Dispositif selon une des revendications précédentes, dans lequel le détecteur (140, 545, 645) est conçu pour détecter que la broche (110), l'outil (120) et la pièce (130) forment

    - une première résistance électrique (190) quand l'outil (120) n'est pas en contact avec la pièce (130) ou qu'aucun outil (120) ou pièce (130) n'est présent,
    - une deuxième résistance électrique (290) quand l'outil (120) est en contact avec la pièce (130), ou
    - une troisième résistance électrique (390) quand l'outil (120) est en contact avec la pièce (130) et que l'outil (120) et/ou la pièce (130) sont défectueux.

8. Dispositif selon la revendication 7, dans lequel le détecteur (645) est en outre conçu pour détecter

    a. la présence d'un outil (120) non correct ou d'une pièce (130) non correcte quand une transition de la première résistance électrique à la deuxième résistance électrique se produit à une distance entre broche (110) et pièce (130) qui est supérieure à une distance prédéfinie et/ou
    b. la présence d'un fonctionnement correct de la machine-outil (100, 400) quand la transition de la première résistance électrique à la deuxième résistance électrique se produit à l'intérieur d'un intervalle de distance prédéfini entre broche (110) et pièce (130) et/ou
    c. l'absence de l'outil (120) quand aucune transition de la première à la deuxième résistance électrique ne se produit à l'intérieur d'un intervalle de distance prédéfini entre broche (110) et pièce (130) et/ou
    d. la présence d'un outil (120) non correct ou d'une pièce (130) non correcte quand une transition de la première résistance électrique à la deuxième résistance électrique se produit à une distance entre broche (110) et pièce (130) qui est inférieure à une distance prédéfinie.

9. Dispositif selon la revendication 8, dans lequel le détecteur (645) est en outre conçu pour détecter la présence d'un outil (120) défectueux ou d'une pièce (130) défectueuse quand une transition de la deuxième résistance électrique à la troisième résistance électrique se produit.

10. Dispositif selon la revendication 8 ou 9, dans lequel le détecteur (645) est conçu pour surveiller que la courbe de variation de la résistance électrique lors de l'usinage de la pièce (130) suit sensiblement une courbe de variation prédéfinie.

11. Dispositif selon la revendication 10, dans lequel la courbe de variation de la résistance électrique lors de l'usinage de la pièce (130) se situe au-dessous d'une première courbe enveloppe prédéfinie ou au-dessus d'une deuxième courbe enveloppe prédéfinie ou à l'intérieur de valeurs de surface prédéfinies.

12. Dispositif selon une des revendications précédentes, dans lequel le détecteur (645) est relié à un système de surveillance (642) de la machine-outil (100, 400), et le système de surveillance (642) est conçu pour interrompre le fonctionnement de la machine-outil (100, 400).

13. Procédé de surveillance d'une machine-outil (100, 400) équipée d'une broche (110) électriquement conductrice lors de l'usinage d'une pièce (130) électriquement conductrice, la broche (110) recevant un outil (120) électriquement conducteur, et la broche (110) et/ou la pièce (130) étant électriquement isolée de la machine-outil (100, 400), lequel procédé présente les étapes consistant à

déterminer un changement de la résistance électrique entre la broche (110) et la pièce (130), **caractérisé en ce qu'**un diviseur de tension comprend au moins deux résistances (502, 504), une prise médiane du diviseur de tension étant reliée de manière électriquement conductrice à la broche (110) et au détecteur (540, 640), et une extrémité du diviseur de tension étant reliée de manière électriquement conductrice à la pièce (130).

**Figuren**

**Fig. 1**

**Fig. 2**

**Fig. 3**

**Fig. 4**

# Fig. 5

**Fig. 6**

**Fig. 7**

700

705 Start

710 $R_x > R_{TH}$? — Nein → 715 Defekt festgestellt Betrieb nicht starten

720 Ende

Ja

725 Vorschub starten

730 $R_1 \rightarrow R_2$, $D > D_{EX}$? — Ja → 735 Werkzeug und/oder Werkstück nicht korrekt

737 Betrieb stoppen

Nein

740 Ende

745 $R_1 \rightarrow R_2$, $D = D_{EX}$? — Nein →

Ja

755 Normalbetrieb

760 $R_1 \rightarrow R_2$, $D > D_{EX}$? — Nein →

765 Ja

791 Werkzeug defekt und/oder Werkstück defekt ← Ja — 785 $R_2 \rightarrow R_3$, $D = D_{EX}$?

Betrieb stoppen

793 Ende 795

787

Nein

789 Bearbeitung abschließen

Ende

Werkzeug und/oder Werkstück nicht korrekt

775 Vorschub endet

780 Werkzeug fehlt

770 Ende

Fig. 8

Fig. 9

Fig. 10

$|U_M - M_{Mo}|$ [V]

D > D$_{EX}$    D < D$_{EX}$    1010

Zeit [s]

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DD 247402 A1
- WO 2006128892 A1
- EP 2165803 A1
- US 3786220 A
- DE 2906892
- DE 102006834
- DE 102004051145 A1
- DE 1033991